# EUROPÄISCHE PATENTSCHRIFT

(11) **EP 1 103 021 B1**
(45) Veröffentlichungstag und Bekanntmachung des Hinweises auf die Patenterteilung: **22.09.2004**
(21) Anmeldenummer: 99940065.8
(22) Anmeldetag: 27.07.1999
(51) Int. Cl.: G05B 19/10, F24C 7/08

(54) **SCHALTUNGSTRAGER MIT ÜBER BUSLEITUNGEN KOMMUNIZIERENDEN STEUERTEILEN**
CIRCUIT SUPPORT WITH CONTROL ELEMENTS COMMUNICATING VIA BUS LINES
SUPPORT DE CIRCUIT A ELEMENTS DE COMMANDE COMMUNIQUANT PAR DES LIGNES BUS

(30) Priorität: 31.07.1998 DE 19834641
(43) Veröffentlichungstag der Anmeldung: 30.05.2001
(73) Patentinhaber: Cherry GmbH, 91275 Auerbach (DE)
(72) Erfinder: TÜRMER, Herbert, D-91275 Auerbach (DE); MILDE, Franz, D-92242 Hirschau (DE)
(74) Vertreter: Neugebauer, Jürgen, Dipl.Phys.
(86) Internationale Anmeldenummer: PCT/EP1999/005387
(87) Internationale Veröffentlichungsnummer: WO 2000/008531

(56) Entgegenhaltungen:
- EP-A- 0 703 181
- DE-A- 3 802 406
- DE-U- 29 619 516

## Beschreibung

Die vorliegende Erfindung betrifft einen Schaltungsträger nach dem Oberbegriff des Anspruchs 1.

Ein derartiger Schaltungsträger ist z.B. aus der DE-U-8 411 149 bekannt.

Zur Steuerung der einzelnen Verbrauchsstellen eines elektrischen Geräts, müssen Steuereinheiten vorgesehen sein, die jeweils individuell die Ansteuerung einer zugeordneten Verbrauchsstelle ermöglichen.

Dies soll im folgenden unter Bezugnahme auf einen elektrischen Herd mit mehreren Kochfeldern als Beispiel für ein elektrisches Gerät mit mehreren Verbrauchsstellen erläutert werden. Die Kochfelder eines solchen Herds können z.B. in Form von einzelnen Elektrokochplatten, in Form von unter einer Glaskeramikplatte angebrachten Infrarotstrahlern, in Form von Induktionsplatten oder in Form anderer zur Erhitzung von darauf abzustellendem Gargut geeigneter Kochplatten ausgeführt sein.

Hierbei werden üblicherweise zwei Alternativen zur individuellen Ansteuerung einzelner Kochfelder beschritten:

### "Zentralistisches" Konzept:

Die Ansteuerung aller Kochfelder erfolgt von einem Schaltungsträger aus, der z.B. in einer Frontpaneele eines Herds angebracht ist. Auf diesem Schaltungsträger sind mehrere Steuereinheiten untergebracht, die vom Benutzer zu betätigende Bedienelemente (z.B. in Form von Drehschaltern, Berührungssensoren oder optoelektronischen Sensoren) aufweisen, durch deren Betätigung die Steuereinheit dazu gebracht wird, bestimmte Kochfelder mit einer zentralen Leistungseinheit zu verbinden, welche die zur Erhitzung des Kochfelds benötigte elektrische Energie bereitstellt.

Bei einem solchen "zentralistischen" Konzept müssen für die einzelnen Bedienelemente sinnfällige Symboliken (Beschriftungen, grafische Zeichen) vorgesehen sein, um dem Benutzer zu verdeutlichen, welches Kochfeld einem bestimmten Bedienelement zugeordnet ist und von diesem angesteuert wird.

Dabei kann es zum Beispiel passieren, daß eine solche Symbolik von einem Benutzer nicht verstanden oder fehlinterpretiert wird, wodurch sich unerwünschte Fehlbedienungen ergeben können.

Zudem erfordert eine solche kompakte Gesamteinheit, auf der alle Steuereinheiten auf einem einzelnen Schaltungsträger untergebracht sind, einen relativ großvolumigen Mindesteinbauraum in einem Herdgehäuse. Dabei können dann gegebenenfalls mehrere kleinere Einbaunischen, die jeweils unter dem Volumen des Mindesteinbauraums liegen, in ihrer Gesamtheit jedoch recht bedeutsame Volumenanteile im Herdinneren ausmachen können, nicht ausgeschöpft werden.

### "Dezentralistisches" Konzept:

Die Ansteuerung der einzelnen Kochfelder erfolgt jeweils von einer in unmittelbarer Nähe eines bestimmten Kochfelds angebrachten und diesem Kochfeld zugeordneten Steuereinheit aus. Durch die enge räumliche Anordnung von Steuereinheit und zugehörigem Kochfeld sind erläuternde Symboliken zur Zuordnung zwischen Steuereinheit und Kochfeld überflüssig. Zum Einbau der einzelnen Steuereinheiten können auch jeweils kleinere Nischenräume im Herdinneren ausgenutzt werden.

Bei der Montage solcher Herde erweist es sich jedoch teilweise als nachteilig, daß zur Verdrahtung der jeweiligen Steuereinheiten mit dem Leistungsteil spezielle Leitungen an der Unterseite der Herdplatten im Herdinneren anzubringen sind.

Zudem kann die Lagerung und Logistik (materialwirtschaftliche Erfassung und Verwaltung) mehrerer einzelner Steuereinheiten in der Praxis zu einem höheren Aufwand führen als bei kompakten Gesamteinheiten, wie sie bei dem oben erläuterten "zentralistischen" Konzept Verwendung finden.

Angesichts der jeweiligen Nachteile der oben erläuterten "zentralistischen" bzw. "dezentralistischen" Einbaukonzepte von Steuereinheiten in den Gehäusen elektrischer Verbraucher liegt der vorliegenden Erfindung die Aufgabe zugrunde, einen Schaltungsträger mit mehreren Steuereinheiten zur Steuerung von individuellen Verbrauchsstellen eines elektrischen Geräts, insbesondere eines Elektroherds mit mehreren Kochstellen, so zu konzipieren, daß er mit einem geringstmöglichen logistischen Aufwand gelagert werden kann, und es gleichzeitig möglich ist, bei der Montage auch kleinere, durch gerätespezifische Einbausituationen vorgegebene Nischenräume in der Nähe der jeweiligen individuellen Verbrauchsstellen durch die Belegung mit den Verbrauchsstellen individuell zugeordneten Steuereinheiten auszunutzen.

Weiterhin soll ein Kompromiß zwischen den obengenannten starren "zentralistischen und "dezentralistischen" Konzepten gefunden werden, und eine variable Lösung angeboten werden, die nach Bedarf zwischen diesen beiden Extremen angepaßt werden kann.

Diese Aufgabe wird durch einen Schaltungsträger nach Anspruch 1 gelöst. Die abhängigen Ansprüche 2 bis 7 betreffen vorteilhafte Ausführungsformen eines solchen Schaltungsträgers.

Der unabhängige Verwendungsanspruch 8 bezieht sich auf die Verwendung eines solchen erfindungsgemäßen Schaltungsträgers in einem Herd mit mehreren individuell erhitzbaren Kochfeldern.

Dadurch, daß einzelne oder alle der Steuereinheiten des erfindungsgemäßen Schaltungsträger voneinander trennbar sind, können sie an durch geometrischräumlichen Zwangsbedingungen im Gehäuse des Geräts vorgegeben Einbaumöglichkeiten jeweils individuell in unmittelbarer Nähe einer einzelnen Verbrauchsstelle angeordnet werden.

Im Falle eines Herds mit mehreren Kochstellen bedeutet dies z.B., daß einzelne Steuereinheiten, welche längs aneinandergrenzender vorbestimmter Teilabschnitte voneinander getrennt worden sind, und dadurch jeweils weniger Platz einnehmen als der komplett vorgefertigte Schaltungsträger, jeweils einzeln in nächster Nähe eines Kochfelds angebracht werden können. Werden die so getrennten Steuereinheiten mittels Überbrückungsleitungen so miteinander verbunden, daß die funktionelle Schaltungstopologie der derart miteinander verbundenen Steuereinheiten wiederum der funktionellen Schaltungstopologie des ursprünglichen Schaltungsträgers entspricht (d.h. z.B., daß im Inneren eines Herdes flexible Busleitungen zwischen den einzelnen Steuereinheiten so angebracht werden, daß die Funktionalität der Busarchitektur vor Durchtrennen der Sollbruchstellen wieder hergestellt ist), so entsteht anschließend aus den dezentral vereinzelten Steuereinheiten wiederum eine im elektrisch-logischen Sinne zu dem Ausgangsschaltungsträger voll äquivalente Schaltung.

Anspruch 9 bezieht sich auf einen Herd mit mehreren individuell erhitzbaren Kochfeldern, in dem ein erfindungsgemäßer Schaltungsträger zur selektiven Steuerung der einzelnen Verbrauchsstellen eingebaut ist, Anspruch 10 betrifft eine vorteilhafte Ausgestaltung eines solchen Herds.

Die Vorteile und Merkmale der vorliegenden Erfindung ergeben sich auch aus den nachfolgenden Ausführungsbeispielen in Verbindung mit den Zeichnungen.

Es zeigen:
- Fig. 1: einen erfindungsgemäßen Schaltungsträger mit voneinander trennbaren Steuereinheiten;
- Fig. 2: eine schematische Darstellung der Busarchitektur des in Fig. 1 gezeigten Schaltungsträgers;
- Fig. 3: eine Anordnung von Steuereinheiten, wie sie dadurch entsteht, daß an dem in Fig. 1 gezeigten Schaltungsträger ein Steuermodul durch Abtrennung vom Rest des erfindungsgemäßen Schaltungsträgers vereinzelt und anschließend durch Zwischenschaltung einer Überbrückungsleitung wiederum mit diesem Rest verbunden worden ist;
- Fig. 4: eine weitere Anordnung, bei der wie bei der in Verbindung mit Fig. 3 beschriebenen Vorgehensweise alle Teilmodule des ursprünglichen Schaltungsträger voneinander abgetrennt und dann über Überbrückungsleitungen miteinander verbunden worden sind;
- Fig. 5: eine Draufsicht auf Kochstellen und Sensorsteuerfelder eines Elektroplattenkochherds, bei dem die in Fig. 1 gezeigte Anordnung von Steuereinheiten verwendet wird;
- Fig.6: eine Draufsicht auf Kochstellen und Sensorsteuerfelder eines Glaskeramikplattenkochherds, bei dem die in Fig. 4 gezeigte Anordnung von Steuereinheiten verwendet wird, wobei die Teilmodule an den Eckpunkten einer Glaskeramikkochplatte angeordnet sind; und
- Fig. 7: eine Seitenansicht eines erfindungsgemäßen Schaltungsträgers mit zugehörigem, beabstandet angebrachten Leistungsteil.

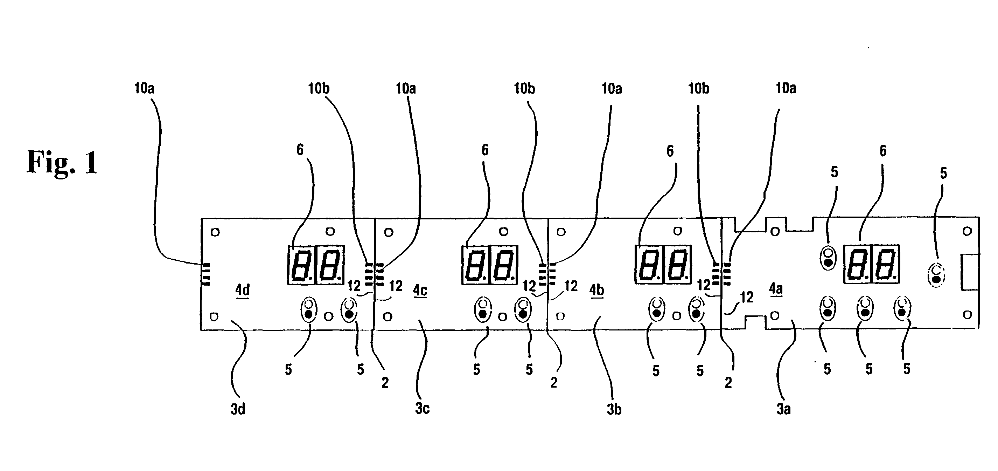

Fig. 1 zeigt eine Draufsicht auf einen erfindungsgemäßen Schaltungsträger 1 mit links und rechts längs Sollbruchlinien 2 jeweils aneinandergrenzend vorbestimmten Teilabschnitten 12. Längs der Sollbruchlinien 2 ist ein mechanisches Trennen der einzelnen räumlichen Bereiche 4a - 4d des Schaltungsträgers 1 voneinander möglich, ohne daß die darauf angebrachten Steuerteile 3a - 3d als solche in Mitleidenschaft gezogen werden. Es müssen jedoch nicht notwendigerweise ausgesprochene Sollbruchstellen vorgesehen sein; erfindungswesentlich ist vielmehr nur, daß in den aneinandergrenzenden Teilbereichen 12 keine Bauelemente der jeweils auf einem der räumlichen Bereiche 4a - 4d angebrachten Steuerteile 3a - 3d vorhanden sind, die bei einem mechanischen Trennen der räumlichen Bereiche 4a - 4d Schaden nehmen.

Der in Fig. 1 gezeigte Schaltungsträger 1 umfaßt ein Mastermodul 3a mit übergeordneten Steuerungsfunktionen sowie drei Slavemodule 3b - 3d mit untergeordneten Steuerungsfunktionen. Die Bedeutung der Begriffe "übergeordnet" und "untergeordnet" wird weiter unten erläutert.

Das Mastermodul 3a und die Slavemodule 3b - 3d sind in jeweils individuell zugeordneten räumlichen Bereichen 4a - 4d des Schaltungsträgers 1 untergebracht. Auf den einzelnen Modulen 3a - 3d sind jeweils elektronische Komponenten einer Steuereinheit wie z.B. Sensoren 5, Anzeigeelemente 6, etc. untergebracht, die auf jedem einzelnen räumlichen Bereich 4a - 4d in einer vorgegebenen Schaltungstopologie zur Erbringung bestimmter schaltungstechnischer Funktionen fest miteinander verbunden sind.

Zwischen diesen räumlichen Bereichen 4a - 4d verlaufen bei dem in Fig. 1 gezeigten Schaltungsträger 1 Sollbruchlinien bzw. -stellen 2. Längs dieser Sollbruchlinien 2 ist eine einfache Trennung der einzelnen räumlichen Bereiche 4a - 4d möglich.

Dies kann optional dadurch erleichtert werden, daß die Sollbruchlinien 2 zwischen zwei benachbarten Teilmodulen 3a - 3d jeweils durch paarig angeordnete, korrespondierende Steckadapterteile 10a, 10b überbrückt werden. Beim Trennen der Teilmodule werden die Steckadapterteile 10a und 10b voneinander gelöst.

Bei der in Fig. 1 gezeigten Ausführungsform eines Schaltungsträgers 1 sind zum Beispiel optoelektronische Sensorfelder 5 vorgesehen, die jeweils aus einer Lichtquelle (z.B. einer Infrarot-LED) und einem licht- bzw. infrarotempfindlichen Sensor bestehen.

Wird ein Finger auf ein solches Infrarotsensorfeld gelegt, so wird das von der Lichtquelle emittierte Licht in den zugehörigen lichtempfindlichen Sensor zurückreflektiert und sodann in diesem ein elektrisches Schaltsignal erzeugt, welches in einer zugeordneten Schaltungslogik verarbeitet werden kann. Abhängig von den Signaleingaben verändert sich sodann der Zustand der Schaltungslogik, welcher z.B. auf den Siebensegmentanzeigefeldern 6 angezeigt werden kann.

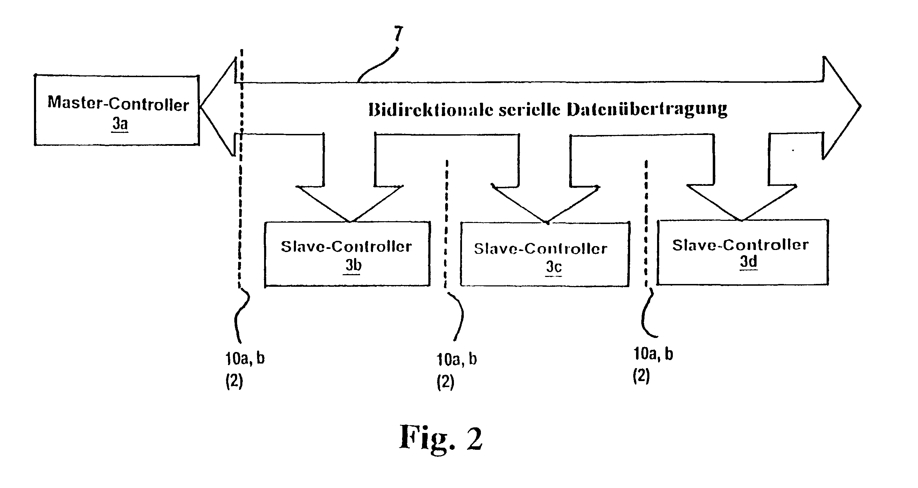

Über die Sollbruchstellen 2 hinweg verlaufen zudem Busleitungen 7 (vgl. Fig. 2) von einem jeden Teilmodul zu benachbarten Teilmodulen. Über diese Busleitungen 7 können Schalt- oder Steuersignale zwischen den Teilmodulen 3a - 3d ausgetauscht werden. Dadurch bildet der gesamte Schaltungsträger 1 mit den sich darauf befindlichen Teilmodulen 3a - 3d eine mechanische und elektronisch-schaltungstechnische Einheit. Somit kann ein kompakter Schaltungsträger 1 mit einer bestimmten kollektiven Schaltungsfunktionalität bereitgestellt werden.

Ein derartiger Schaltungsträger 1 bietet z.B. Vorteile bei der Lagerung bzw. der Materialbewirtschaftung im Produktionsfluß, und bei der Handhabung, da die gesamte kollektive Schaltungsfunktionalität in einem kompakten Bauteil untergebracht ist.

Fig. 2 zeigt eine schematische Darstellung der Busarchitektur des Fig. 1 gezeigten Schaltungsträgers 1. Linksliegend in Fig. 2 ist das in Fig. 1 rechts liegende Mastermodul 3a schematisch dargestellt. Dieses Mastermodul 3a kontrolliert z.B. über eine bidirektionale Busleitung 7 die serielle Datenübertragung zwischen dem Mastermodul 3a und den einzelnen Slavemodulen 3b - 3d. In Fig. 2 sind die Sollbruchlinien 2 bzw. die Steckadapterteile 10a und 10b zwischen den einzelnen Steuermodulen schematisch durch gestrichelte Linien angedeutet.

Der in Fig. 1 gezeigte Schaltungsträger 1 kann z.B. in einem Herd zur Steuerung mehrerer einzelner Kochfelder eingesetzt werden. Dabei kann z.B. das Mastermodul 3a die Funktion eines Hauptschalters haben, der als "EIN/AUS"-Schalter für den Herd wirkt, oder ein übergeordneter Programmwahlschalter sein, mit dem z.B. bestimmte zeitliche Steuerungscharakteristiken für die einzelnen Herdplatten vorgegeben werden (z.B. Unterbrechung der Stromzufuhr nach einer vom Benutzer freiwählbaren Zeit, so daß dieser nach Einschalten des Herdes das Haus in der Gewißheit verlassen kann, daß der Herd nach Ablauf der gewählten Zeitspanne ausgeschaltet wird).

Hat das Steuermodul 3a die Funktion eines Mastermoduls zur Steuerung eines Hauptschalters, so können die drei in Fig. 1 verbleibenden Steuermodule 3b - 3c die Funktion untergeordneter Slavemodule aufweisen, die nach Einschalten des Hauptschalters über das Mastermodul 3a zur Ansteuerung von z.B. drei Kochplatten verwendet werden können.

Bei dem in Fig. 1 gezeigten Schaltungsträger 1 umfassen die Teilmodule 3a - 3d z.B. Infrarotsensorfelder 5. Wird ein Infrarotsensorfeld 5 auf einem Steuermodul 3a - 3d durch einen Finger angetippt, so wird z.B. ein zugehöriges Kochfeld von einer Leistungseinheit mit elektrischer Energie gespeist.

Durch die in Fig. 2 gezeigte Busarchitektur wird der gesamte Datenaustausch zwischen dem Mastermodul 3a und den einzelnen Slavemodulen 3b - 3d durch den Schaltungsträger 1 hindurchgeführt.

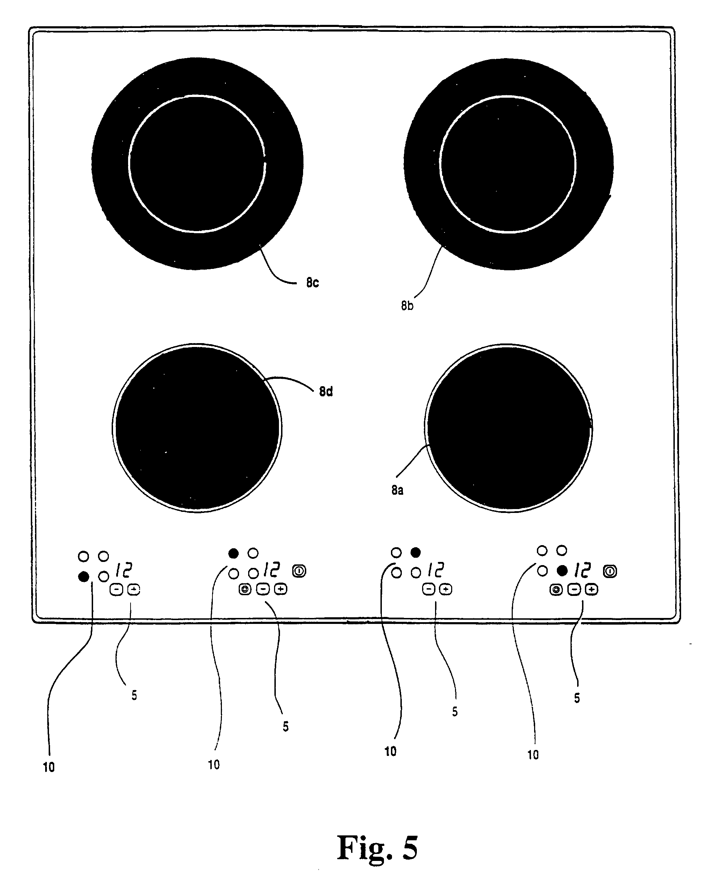

Der in Fig. 1 gezeigte Schaltungsträger 1 kann bei Bedarf in einem kompletten Stück in ein Gerät mit mehreren elektrischen Verbrauchern eingebaut werden. Hat man z.B. einen Elektroherd bei dem Infrarotkochfelder auf einer Glaskeramikplatte angebracht sind, und bei dem in der Nähe der einzelnen Kochfelder 8a - 8d keine Möglichkeit besteht, individuell zugeordnete Sensorsteuerungen anzubringen, so kann man z.B. die in Fig. 5 gezeigte Anordnung erhalten. Mangels Platz in der Nähe der einzelnen Kochfelder 8a - 8d sind hier also alle Sensorsteuerungsfelder 5 an einem zentralen Platz in der Nähe der Vorderfront des Herds angebracht worden. Es handelt sich also um eine Realisierung des oben erläuterten "zentralistischen" Konzepts, bei dem gegebenenfalls erläuternde Symboliken 10 im Bereich der einzelnen Sensorfelder 5 angebracht sein müssen, um deren Zuordnung zu den einzelnen Kochfeldern 8 zu veranschaulichen (ein schwarzer Kreis symbolisiert die Lage der angesprochenen Herdplatte relativ zu den anderen, durch Kreisringe symbolisierten Herdplatten).

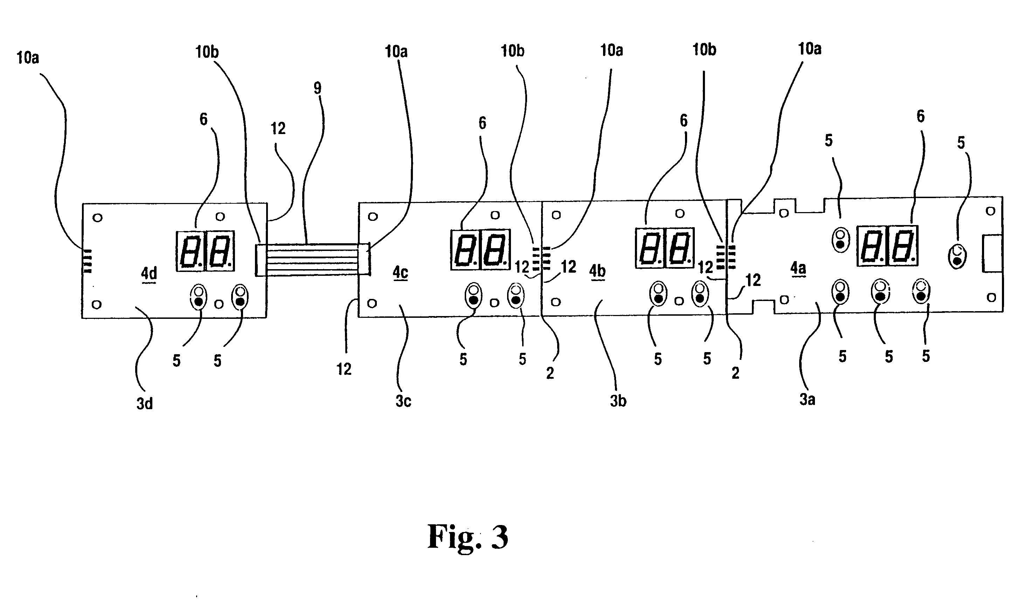

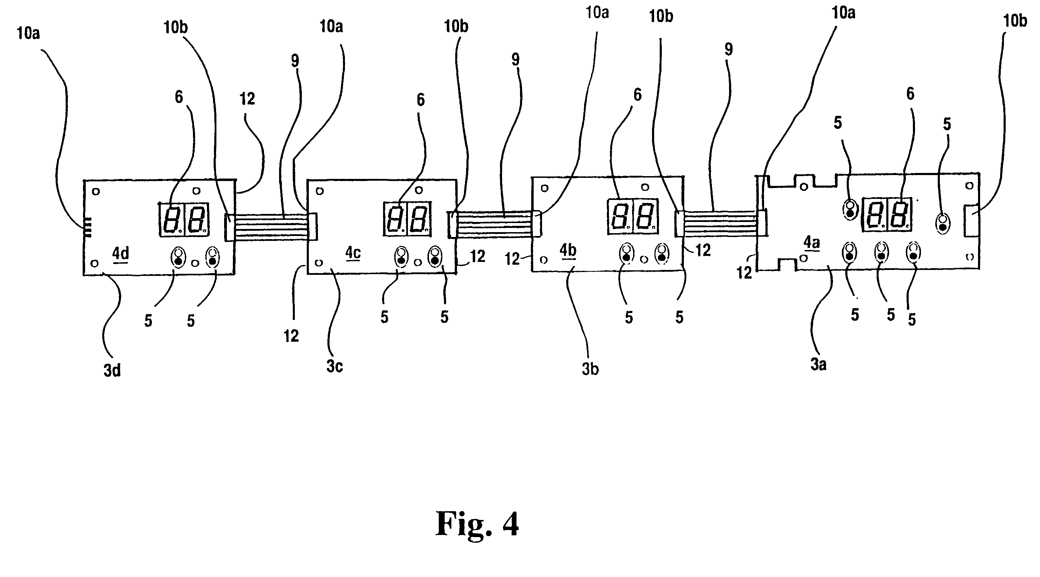

Hat man jedoch in einem entsprechenden Herd mit Infrarotkochfeldern aufgrund typenspezifischer baulicher Besonderheiten im Herdinneren in der Nähe der Kochfelder 8a - 8d noch Raum, um einzelne jeweils kochfeldspezifische Steuermodule unterzubringen, so kann man den in Fig. 1 gezeigten Schaltungsträger 1 längs der einzelnen Sollbruchlinien 2 z. B. durch Trennen der korrespondierenden Steckadapterteile 10a, 10b in einzelne Teilmodule 3a - 3d aufspalten. Diese können dann, wie in Fig. 3 oder 4 gezeigt, räumlich voneinander getrennt angeordnet werden und untereinander z.B. durch an die Steckadapterteile 10a, 10b anzuschließende flexible Busleitungen 9 verbunden werden.

Die Verbindung über flexible Busleitungen 9 ist ein einfach zu bewerkstelligender Arbeitsgang und führt zu einer elektrischen Kontaktierung der einzelnen Teilmodule 3a - 3d, welche als Kollektiv wiederum exakt die gleiche schaltungstechnische Gesamtfunktionsamtfunktion wie der Schaltungsträger 1 aufweisen.

Durch die räumliche Trennung der einzelne Teilmodule 3a - 3d ist es jetzt jedoch möglich, diese in der Nähe der einzelnen Kochfelder 8a - 8d anzubringen.

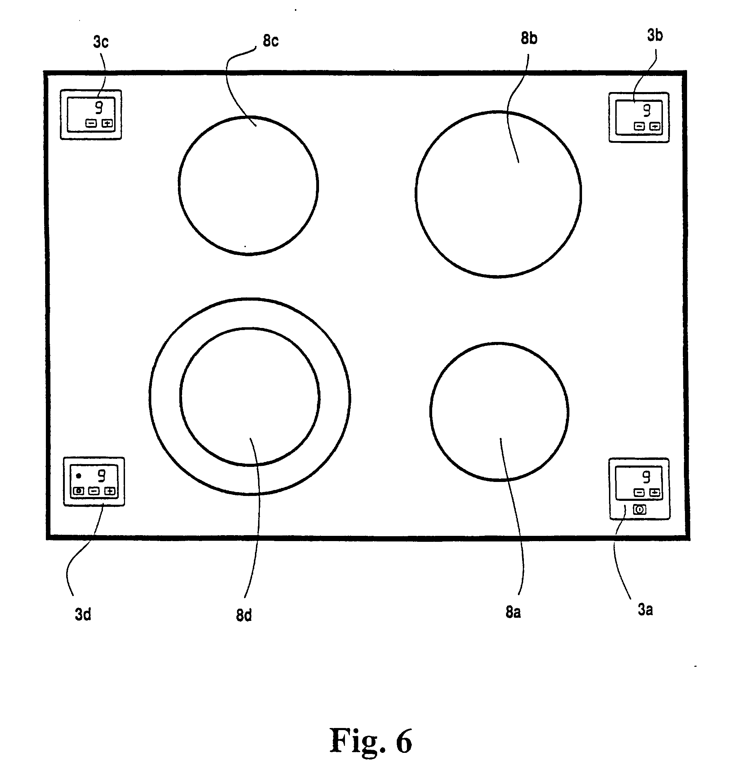

Verwendet man hierzu die in Fig. 4 gezeigte Anordnung von vier voneinander getrennten aber über Überbrückungsleitungen 9 miteinander verbundenen Steuereinheiten 3a - 3d, die in etwa an den Eckpunkten einer in Fig. 6 in Draufsicht gezeigten Glaskeramikkochplatte eines Herdes mit vier Kochstellen 8a - 8d angeordnet werden, so erhält man eine Anordnung mit den einzelnen Kochstellen 8a - 8d jeweils unmittelbar (also dezentral) zugeordneten Steuermodulen 3a - 3d.

Durch die erfindungsgemäßen Maßnahmen wird ein Schaltungsträger bereitgestellt, welcher äußerst flexibel an die jeweils typspezifischen Einbausituationen anpaßbar ist. Dies führt insbesondere auch in der Produktionstechnik bei der Herstellung von mehreren abgewandelten Typen einer bestimmten Art von elektrischen Geräten mit von Typ zu Typ variierender Anordnung der einzelnen elektrischen Verbrauchsstellen im Gerätetyp zu einer höheren Flexibilität und Variabilität der Produktpalette. Denn nunmehr ist es möglich, mit einem einzelnen Typ von erfindungsgemäßen Schaltungsträgern eine Vielzahl von Modellvarianten von elektronischen Geräten mit jeweils unterschiedlichen räumlichen Einbausituationen bezüglich der Steuerschaltungen für die einzelnen Verbrauchsstellen zu bedienen. Zusätzlich ergeben sich auch erhebliche wirtschaftliche Vorteile bei der Lagerhaltung und Logistik, da nicht mehr für jeden Einzeltyp von Endgerät unterschiedliche Typen von Steuerschaltungen verwaltet und gelagert werden müssen.

Soll der erfindungsgemäße Schaltungsträger tatsächlich zur Steuerung der Energieversorgung von elektrischen Verbrauchern verwendet werden, so muß noch ein zusätzliches Leistungsteil bereitgestellt werden, welches die eigentliche Energieversorgung des Verbrauchers bewirkt.

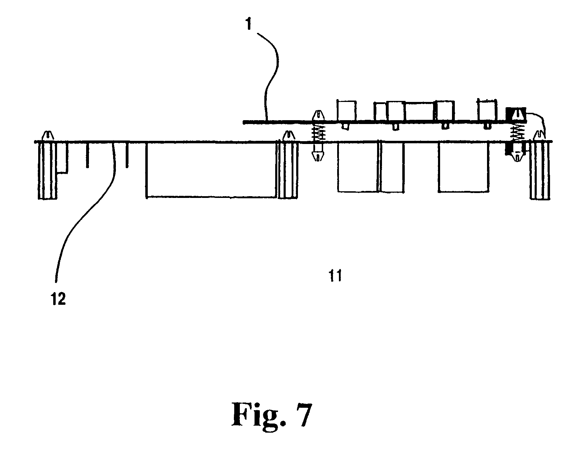

Als vorteilhaft erweist sich dabei in der Praxis auch, wenn der Schaltungsträger mit einem separaten Leistungsteil fest verbunden ist, also ein kompaktes Gesamtbauteil bildet, von dem die einzelnen Steuerungsteilmodule nach Bedarf herausgelöst werden können. Besonders vorteilhaft ist dabei wiederum, wenn bei einem wie in Fig. 7 gezeigten Aufbau das Leistungsteil 11 auf einem zweiten Schaltungsträger 12 angebracht ist, welcher vom ersten Schaltungsträger 1 beabstandet angebracht ist.

Durch einen solchen zweistufigen Aufbau wird ein besonders kompaktes Gesamtbauteil bereitgestellt.

## Patentansprüche

1. Einstückig integrierter Schaltungsträger (1) mit definierter ursprünglicher funktioneller Schaltungstopologie mit mehreren über Leitungen miteinander kommunizierenden elektrischen Komponenten,
wobei die elektrischen Komponenten auf dem Schaltungsträger in einem jeweils zugeordneten räumlichen Bereich (4a - 4d) angeordnet sind, wobei diese individuellen räumlichen Bereiche über die mit dem Schaltungsträger (1) fest verbundenen Leitungen miteinander verbunden sind, und die räumlichen Bereiche samt den sie verbindenden Leitungsabschnitten so beschaffen sind, dass sie jeweils aneinandergrenzende vorbestimmte Teilabschnitte mit Sollbruchstellen bzw. Sollbruchlinien (2) enthalten, längs derer ein mechanisches Trennen der einzelnen räumlichen Bereiche (4a - 4d) voneinander möglich ist, ohne das die darauf angebrachten elektrischen Komponenten als solche in Mitleidenschaft gezogen werden,
**dadurch gekennzeichnet,**
**daß** die Leitungen über die Sollbruchstellen (2) verlaufende Busleitungen (7) sind und die elektrischen Komponenten Steuerteile (3a - 3d), welche über diese Busleitungen (7) miteinander kommunizieren,
wobei zwischen den Steuerteilen (3a - 3d) eine funktionale Hierarchie herrscht und zumindest ein übergeordnetes zentrales Steuerteil (3a) zur Koordination der Steuerung für die verbleibenden untergeordneten Steuerteile (3b - 3d) dient,
**daß** jedes Steuerteil jeweils Eingabeelemente (5) zur Eingabe von Stellgrößen umfaßt,
**daß** die Busleitungen längs der Sollbruchstellen auftremmbar sind und die dann getrennten Steuereinheiten mittels Überbrückungsleitungen so miteinander verbindbar sind, daß die definierte funktionelle Scholtungstopologie von miteinander, mittels solcher Überbruckungs leitungen, verbundenen Steuerinheitem wieder der definerten ursprünglichen funktionellen Scholtungstopologie entspricht.

2. Schaltungsträger nach Anspruch 1,
**dadurch gekennzeichnet,**
**daß** jeweils Anzeigeelemente (6) zur Veranschaulichung der durch die Eingabeelemente (5) ausgelösten Stellgrößen in den einzelnen räumlichen Bereichen (4a -4d) vorgesehen sind.

3. Schaltungsträger nach Anspruch 1 oder 2,
**dadurch gekennzeichnet,**
**daß** im Bereich der aneinandergrenzenden vorbestimmten Teilabschnitte (12) jeweils voneinander lösbare korrespondierende Steckadapterteile (10a, 10b) vorgesehen sind.

4. Schaltungsträger nach einem der vorstehenden Ansprüche,
**dadurch gekennzeichnet,**
**daß** der Schaltungsträger (1) mit einem separaten Leistungsteil (11) verbunden ist.

5. Schaltungsträger nach Anspruch 4,
**dadurch gekennzeichnet,**
**daß** das Leistungsteil (11) auf einem zweiten Schaltungsträger (12) angebracht ist, welcher vom ersten Schaltungsträger (1) beabstandet angebracht ist.

6. Schaltungsträger nach einem der vorstehenden Ansprüche,
**dadurch gekennzeichnet,**
**daß** die Busleitungen (7) zwischen den Steuereinheiten (3a - 3d) eine bidirektionale serielle Busarchitektur aufweisen.

7. Verfahren zur Montage eines Schaltungsträgers (1) nach einem der vorhergehenden Ansprüche im Gehäuse eines elektrischen Geräts, welches folgende Schritte umfaßt:
Trennen einzelner oder aller Steuereinheiten (3a - 3d) des Schaltungsträgers voneinander längs der aneinandergrenzenden vorbestimmten Teilabschnitte (4a - 4d);
Anordnen der Steuereinheiten jeweils individuell in unmittelbarer Nähe eines einzelnen elektrischen Verbrauchers im Gehäuse des Geräts unter Berücksichtigung der durch geometrisch-räumliche Zwangsbedingungen vorgegebenen Einbaumöglichkeiten;
Verbinden von längs aneinandergrenzender vorbestimmter Teilabschnitte (4a - 4d) getrennten Steuereinheiten (3a - 3d) mittels Überbrückungsleitungen (9), so daß die funktionelle Schaltungstopologie der derart miteinander verbundenen Steuereinheiten (3a - 3d) wiederum der funktionellen Schaltungstopologie des ursprünglichen Schaltungsträgers (1) entspricht.

## Claims

1. A one-piece, integrated circuit platform (1) having a defined, original functional circuit topology comprising a plurality of electric components each communicating with the other via conductors,
said electric components each being arranged on said circuit platform in separately assigned spatial zone (4a - 4d), said individual spatial zones being interconnected via conductors fixedly connected to said circuit platform (1), and said spatial zones together with their interconnecting conductor portions being formed so that they each comprise predefined, juxtaposed segments with designed frangible locations or lines (2) along which it is possible to mechanically separate said individual spatial zones (4a - 4d) from each other without detrimenting said electrical components circuited thereon,
**characterized in that**
said conductors are bus conductors (7) running via said designed frangible locations (2) and said electric components are controllers (3a - 3d) intercommunicating via said bus conductors (7),
a functional hierarchy existing between said controllers (3a - 3d) and at least one master controller (3a) serving to control the remaining slave controllers (3b - 3d),
each controller comprising elements (5) for inputting manipulated variables,
said bus conductors being partable along said designed frangible locations and said parted controllers then being interconnectable via link conductors to reconform the defined functional circuit topology of controllers interconnected by such link conductors to said defined original functional circuit topology.

2. The circuit platform as set forth in claim 1, **characterized in that** display elements (6) for indicating said manipulated variables prompted by said input elements (5) are provided in said individual spatial zones (4a - 4d).

3. The circuit platform as set forth in claim 1 or 2, **characterized in that** in the region of juxtaposed, predefined segments (12) corresponding connecting adapter parts (10a, 10b) each disconnectable from the other are provided.

4. The circuit platform as set forth in any of the preceding claims, **characterized in that** said circuit platform (1) is connected to a separate power part (11).

5. The circuit platform as set forth in claim 4, **characterized in that** said power part (11) is mounted on a second circuit platform (12) separate from said first circuit platform (1).

6. The circuit platform as set forth in any of the preceding claims, **characterized in that** said bus conductors (7) between said controllers (3a - 3d) comprise a bidirectional serial bus architecture.

7. A method for assembling a circuit platform as set forth in any of the preceding claims in the housing of an electrical appliance, comprising the steps:
parting single or all controllers (3a - 3d) of said circuit platform from each other along said juxtaposed predefined segments (4a - 4d);
locating each controller individually in the direct vicinity of a single electrical consumer in said appliance housing, taking into account space availability as dictated by the existing geometrical-spatial restrictions;
connecting said controllers (3a - 3d) parted from said lengthwise juxtaposed predefined segments (4a - 4d) via link conductors (9) to reconform the defined functional circuit topology of such interconnected controllers (3a - 3d) to the functional circuit topology of the original circuit platform (1).

## Revendications

1. Support de circuit (1) intégré d'une pièce présentant une topologie de circuit fonctionnelle initiale définie et comportant plusieurs composants électriques communiquant entre eux par des lignes,
les composants électriques étant disposés sur le support de circuit (1) dans un espace (4a, 4b) associé à chacun, lesdits espaces individuels étant reliés entre eux par l'intermédiaire des lignes fermement raccordées au support de circuit (1), et les espaces y compris les sections de ligne les raccordant étant conçus de manière à ce qu'ils comprennent chacun des sections partielles avoisinantes prédéterminées présentant des points ou des lignes de rupture programmés (2) le long desquels une séparation mécanique des divers espaces (4a - 4d) l'un de l'autre est possible sans que ne soient affectés en tant que tels les composants électriques qu'ils portent,
**caractérisé en ce que**
les lignes sont des lignes bus (7) s'étendant par-dessus les points de rupture programmés (2) et les composants électriques sont des éléments de commande (3a - 3d) qui communiquent entre aux par l'intermédiaire desdites lignes bus (7), entre les éléments de commande (3a - 3d) régnant une hiérarchie fonctionnelle et au moins un élément de commande central (3a) prioritaire servant à la coordination de la commande des éléments de commande (3b - 3d) restants subordonnés,
chaque élément de commande comporte des éléments d'entrée (5) pour entrer des grandeurs de commande,
les lignes bus peuvent être séparées le long des points de rupture programmés et les éléments de commande alors séparées peuvent être raccordés entre eux par des lignes de pontage de manière à ce que la topologie de circuit fonctionnelle définie d'éléments de commande raccordés entre eux au moyen de telles lignes de pontage correspond à la topologie de circuit fonctionnelle initiale définie.

2. Support de circuit selon la revendication 1, **caractérisé en ce que** des éléments d'affichage (6) pour visualiser les grandeurs de commande déclenchées par les éléments d'entrée (5) sont prévus dans chacun des divers espaces (4a - 4d).

3. Support de circuit selon les revendications 1 ou 2, **caractérisé en ce que** dans la zone de chacune des sections partielles (12) avoisinantes prédéterminées des pièces d'adaptateur enfichables (10a, 10b) correspondantes et détachables l'une de l'autre sont prévues.

4. Support de circuit selon l'une quelconque des revendications précédentes, **caractérisé en ce que** le support de circuit (1) est raccordé à un élément de puissance (11 ) séparé.

5. Support de circuit selon la revendication 4, **caractérisé en ce que** l'élément de puissance (11) est logé sur un second support de circuit (12) qui est logé à distance du premier support de circuit (1).

6. Support de circuit selon l'une quelconque des revendications précédentes, **caractérisé en ce que** les lignes bus (7) présentent une architecture à bus sérielle bidirectionnelle entre les éléments de commande (3a - 3d).

7. Procédé pour le montage d'un support de circuit (1) selon l'une quelconque des revendications précédentes dans le boîtier d'un appareil électrique, qui comporte les étapes suivantes :
séparer diverses ou toutes les unités de commande (3a - 3d) du support de circuit l'une de l'autre le long des sections partielles (4a - 4d) avoisinantes prédéterminées ;
placer chacun des éléments de commande individuellement à proximité directe d'un consommateur électrique individuel dans le boîtier de l'appareil, compte tenu des possibilités d'encastrement imposées par les conditions géométriques et spatiales ;
raccorder des éléments de commande (3a - 3d) séparés le long de sections partielles (4a - 4d) avoisinantes prédéterminées au moyen de lignes de pontage (9) de manière à ce que la topologie de circuit fonctionnelle des éléments de commande (3a - 3d) raccordés entre eux de la sorte correspond à nouveau à la topologie de circuit fonctionnelle du support de circuit (1) initial.
